(19) Europäisches Patentamt
European Patent Office
Office européen des brevets

(11) **EP 4 722 805 A2**

(12) **EUROPEAN PATENT APPLICATION**

(43) Date of publication:
08.04.2026 Bulletin 2026/15

(21) Application number: 25205553.8

(22) Date of filing: 30.09.2025

(51) International Patent Classification (IPC):
**G03F 1/24** (2012.01)  **G03F 1/38** (2012.01)
**G03F 1/84** (2012.01)

(52) Cooperative Patent Classification (CPC):
**G03F 1/24; G03F 1/38; G03F 1/84**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: 07.10.2024 JP 2024175769

(71) Applicant: Shin-Etsu Chemical Co., Ltd.
Tokyo 100-0005 (JP)

(72) Inventors:
• **Takeda, Atsuhiro**
**Niigata (JP)**
• **Muneyasu, Riku**
**Niigata (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

(54) **REFLECTIVE MASK BLANK AND METHOD FOR MANUFACTURING THE SAME**

(57) A reflective mask blank having auxiliary marks that can be formed with a simple structure and little risk of particle generation in a reference mark is provided. A reflective mask blank including at least a substrate, a multilayer reflective film provided on the substrate and reflecting exposure light, and an absorber film provided on the multilayer reflective film and absorbing the exposure light, in which the reflective mask blank further includes a reference mark formed on a surface on a same side as the multilayer reflective film of the reflective mask blank, the reference mark consists of a main mark serving as a reference position for a defect position, and an auxiliary mark group disposed around the main mark, the auxiliary mark group consists of a plurality of auxiliary marks formed at intervals from one another to extend in at least one direction starting from the main mark, and the plurality of auxiliary marks are all formed in a same shape and in a same orientation.

[FIG. 1]

EP 4 722 805 A2

## Description

TECHNICAL FIELD

The present invention relates to a reflective mask blank used in semiconductor device manufacturing and the like and a method for manufacturing the same.

BACKGROUND ART

In the manufacturing process of semiconductor devices (semiconductor apparatuses), photolithography technology to irradiate a transfer mask with exposure light and transfer a circuit pattern formed on the mask onto a semiconductor substrate (semiconductor wafer) via a reduction projection optical system is used repeatedly. Conventionally, a wavelength of the exposure light has been mainly 193 nm using argon fluoride (ArF) excimer laser light, and by adopting a process called multi-patterning which combines an exposure process and a processing process a plurality of times, patterns with dimensions smaller than the exposure wavelength have been ultimately formed.

However, as device patterns continue to become finer, formation of even finer patterns is required, and therefore extreme ultraviolet (hereinafter, referred to as "EUV") lithography technology, which uses EUV light with an even shorter wavelength than ArF excimer laser light as exposure light has begun to be used. EUV light is light with a wavelength of about 0.2 to 100 nm, and more specifically light with a wavelength in a vicinity of 13.5 nm. Since the EUV light has extremely low transmittance to materials, and conventional transmission type projection optical systems and masks cannot be used, reflection type optical elements are used. In addition, as for the mask for pattern transfer, reflective masks are also proposed.

A reflective mask is such that a multilayer reflective film that reflects EUV light is formed on the substrate, and an absorber film that absorbs the EUV light is formed in a pattern form on the multilayer reflective film (hereinafter, this will be referred to as an EUV reflective mask). On the other hand, what is in a state before patterning the absorber film (including a state in which a resist film is formed) is called a reflective mask blank, and this is used as a raw material of the reflective mask (hereinafter, this will be referred to as an EUV reflective mask blank).

In an EUV reflective mask, if there is a defect in a recessed or protruded shape in the surface layer thereof or in the film, the reflectance of the EUV light is reduced in a defect portion, and it is impossible to obtain a desired transfer pattern during wafer exposure. In particular, if a defect exists in the multilayer reflective film, or between the multilayer reflective film and the substrate, even if the defect is only a few nm in height, a phase shift of the reflection light of the EUV light occurs around it due to collapse of the periodic structure of the multilayer reflective film, which causes local reduction in reflectance. This has a particularly large effect on the pattern shape transferred to the wafer. The defect like this is called a phase defect. A phase defect is difficult to repair because it is located in or under the film. On the other hand, defects that exist on the multilayer reflective film and on the absorber film attenuate the intensity of the reflection light of the EUV light, and thus they are called amplitude defects in contrast to phase defects.

In order to avoid the effect on the transfer pattern by the phase defect and the amplitude defect, defect mitigation (hereinafter, referred to as a DM technology) that covers up phase defects with absorber patterns is proposed. In the DM technology, it is realized by identifying the defect position in the coordinate system defined by a reference mark produced on the EUV reflective mask blank by defect inspection, and obtaining defect position information on the EUV reflective mask blank in the coordinate system in the mask shop, by the mask shop measuring a reference mark position, and performing a proper coordinate conversion.

CITATION LIST

PATENT LITERATURE

Patent Document 1: JP 6713251 B

SUMMARY OF INVENTION

TECHNICAL PROBLEM

Patent Document 1 describes formation of a low-cost reference mark with high precision by dividing the reference mark into a main mark and an auxiliary mark, forming the main mark by FIB (Focused Ion Beam), and forming the auxiliary mark by indentation with a micro-indenter. In addition, it is proposed to form the auxiliary mark that does not damage the substrate and makes it easy to reproduce the substrate by making the length of the long side of the auxiliary mark in plan view 200 $\mu$m or more and 600 $\mu$m or less, and making the depth equal to or less than the thickness of the multilayer reflective film. In order to form the above-described auxiliary marks on the top, bottom, left and right of the main mark, the example of Patent Document 1 cites a method in which the micro-indenter is rotated around the main mark. However, in this case, the rotation axis of the micro-indenter and the swing-down axis of the micro-indenter have to be provided to be offset, which complicates the mechanism. In addition, since the rotation mechanism is provided on the substrate, the risk of particle generation increases.

The present invention, which has been made to solve the above-described problem, aims to provide a reflective mask blank, which has an auxiliary mark that can be formed with a simple mechanism and little risk of particle generation in a reference mark, and a method for manufacturing the same.

SOLUTION TO PROBLEM

To achieve the object, the present invention provides a reflective mask blank comprising at least:

a substrate;
a multilayer reflective film provided on the substrate, the multilayer reflective film reflecting exposure light; and
an absorber film provided on the multilayer reflective film, the absorber film absorbing the exposure light, wherein
the reflective mask blank further comprises a reference mark formed on a surface on a same side as the multilayer reflective film of the reflective mask blank,
the reference mark consists of a main mark serving as a reference position for a defect position, and an auxiliary mark group disposed around the main mark,
the auxiliary mark group consists of a plurality of auxiliary marks formed at intervals from one another to extend in at least one direction starting from the main mark, and
the plurality of auxiliary marks are all formed in a same shape and in a same orientation.

With the reflective mask blank of the present invention, the auxiliary marks in the reference mark can be formed with a simple structure and little risk of particle generation. The auxiliary marks by the complicated mechanism with a high risk of particle generation as in the conventional technology is not required, and the present invention can be a lower-cost, lower-defect reflective mask blank (in particular, an EUV reflective mask blank) with a reference mark.

At this time, each of the auxiliary marks can be a recessed portion in an inverted cone or pyramid shape with a vertex angle of 55 degrees or more, a recessed portion in an inverted hipped roof shape with a ridge having a length of 50 $\mu$m or less, or a recessed portion in an inverted truncated quadrangular pyramid shape with a top surface having a long-side length of 50 $\mu$m or less.

For example, when the depth of the auxiliary mark, which is formed by indentation with a micro-indenter, is suppressed to the thickness of the multilayer reflective film or less, the depth is very small relative to the length (size) of the auxiliary mark in plan view, and in order to obtain a desired shape with good reproducibility, there arises the necessity of pressing the micro-indenter against the substrate extremely parallel. In this case, for the shape reproduction, high precision is required in attachment of the micro-indenter and installation of the substrate. However, when the auxiliary mark (in other words, the micro-indenter in this case) has a specific shape as described above, excessive precision is not required in the attachment of the micro-indenter and installation of the substrate, and the auxiliary mark becomes an auxiliary mark whose shape is easily reproduced.

Furthermore, the auxiliary marks can be formed on a same layer as the main mark, or above (side apart from the substrate) a layer on which the main mark is formed.

With the auxiliary mark as above, it is possible to form the auxiliary mark with the main mark as a landmark when forming the auxiliary mark, and the auxiliary mark is formed more easily.

Further, the present invention provides a method for manufacturing a reflective mask blank comprising at least steps of:

forming a multilayer reflective film on a substrate, the multilayer reflective film reflecting exposure light; and
forming an absorber film on the multilayer reflective film, the absorber film absorbing the exposure light, wherein
the method further comprises a step of forming a reference mark on a surface on a same side as the multilayer reflective film of the reflective mask blank, the reference mark consisting of a main mark serving as a reference position for a defect position, and an auxiliary mark group disposed around the main mark,
when forming the auxiliary mark group of the reference mark, a plurality of auxiliary marks are all formed in a same shape and in a same orientation at intervals from one another to extend in at least one direction starting from the main mark, by an indentation method with a micro-indenter, and thereby the auxiliary mark group consisting of the plurality of auxiliary marks is formed.

With the method for manufacturing the reflective mask blank of the present invention, it is possible to form the auxiliary marks in the reference mark with a simple mechanism and little risk of particle generation. Therefore, it is possible to provide a lower-cost, lower-defect reflective mask blank (in particular, an EUV reflective mask blank) with a reference mark than the conventional one.

At this time, as the micro-indenter, it is possible to use a micro-indenter in an inverted cone or pyramid shape with a vertex angle of 55 degrees or more, a micro-indenter in an inverted hipped roof shape with a ridge having a length of 50 $\mu$m or less, or a micro-indenter in an inverted truncated quadrangular pyramid shape with a top surface having a long-side length of 50 $\mu$m or less.

By using the one in a specific shape as described above as the micro-indenter as above, it is possible to form the auxiliary marks with high reproducibility of the shape without requiring excessive precision in attachment of the micro-indenter and installation of the substrate.

Further, when forming the main mark, the main mark can be formed by FIB processing.

By doing as above, it is possible to perform formation of the main mark with high precision.

Further, when forming the auxiliary marks, a defect inspection machine equipped with the micro-indenter can be used.

Some of the defect inspection machines each include the indentation function equipped with a micro-indenter, and in that case, it is not necessary to newly introduce an apparatus to form the auxiliary marks, and it is possible to reduce cost.

Further, the auxiliary marks can be formed after formation of the main mark.

By doing as above, it is possible to form the auxiliary marks with the main mark as a landmark, and excessive processing position precision is not required concerning the apparatus for forming the auxiliary marks, which is convenient.

ADVANTAGEOUS EFFECTS OF INVENTION

According to the reflective mask blank and the method for manufacturing the same of the present invention, it is possible to form the auxiliary marks without requiring formation of the auxiliary marks by the complicated mechanism with a high risk of particle generation as in the conventional technology. For this reason, it is possible to provide a lower-cost, lower-defect reflective mask blank with a reference mark.

BRIEF DESCRIPTION OF DRAWINGS

FIG. 1 is an example of a schematic sectional view of a reflective mask blank of the present invention;
FIG. 2 is a schematic plan view showing a disposition example of a reference mark in the present invention;
FIG. 3 is a view showing a shape example and a disposition example of a main mark and auxiliary mark groups that configure the reference mark in the present invention;
FIG. 4 shows examples of a schematic view of a shape in plan view of the main mark in the present invention;
FIG. 5 shows examples of schematic views of a perspective shape and a planar shape of the auxiliary mark (a perspective shape and a planar shape of a micro-indenter) in the present invention;
FIG. 6 is a schematic view showing a sectional shape of the auxiliary mark when the micro-indenter is in a cone or pyramid shape, and a substrate surface when a substrate is tilted; and
FIG. 7 is a schematic view of a sectional shape of the auxiliary mark when the micro-indenter is in a hipped roof shape, and a substrate surface when the substrate is tilted.

DESCRIPTION OF EMBODIMENTS

As described above, concerning the auxiliary marks in the reference mark of the reflective mask blank, the auxiliary marks that can be formed with a simple mechanism and little risk of particle generation have been required.

Thus, when the present inventor has conducted extensive research into reflective mask blanks, the present inventor has accomplished the present invention by finding that it is possible to provide a low-cost, low-defect reflective mask blank with a reference mark, in which the auxiliary marks can be formed with a simple mechanism and with little risk of particle generation, by adopting a reflective mask blank (including at least a multilayer reflective film and an absorber film on a substrate) including a reference mark (a main mark and an auxiliary mark group) formed on a surface on a same side as the multilayer reflective film, the auxiliary mark group consisting of a plurality of auxiliary marks formed at intervals from one another to extend in at least one direction starting from the main mark, and the plurality of auxiliary marks being all formed in a same shape and in a same orientation.

Further, in a method for manufacturing the reflective mask blank, the present inventor has accomplished the present invention by finding that it is possible to form auxiliary marks in a reference mark with a simple mechanism and with little risk of particle generation, and it is possible to manufacture the low-cost, low-defect reflective mask blank with a reference mark, by having a step of forming a reference mark (a main mark and an auxiliary mark group) on a surface on a same side as a multilayer reflective film of a reflective mask blank, in which when the auxiliary mark group of the reference mark is formed, the auxiliary mark group consisting of the plurality of auxiliary marks is formed by forming all the plurality of auxiliary marks in a same shape and a same orientation at intervals from one another to extend in at least one direction starting from the main mark, by an indentation method with a micro-indenter.

Hereinafter, an embodiment of the present invention will be described with reference to the drawings, but the present invention is not limited to this.

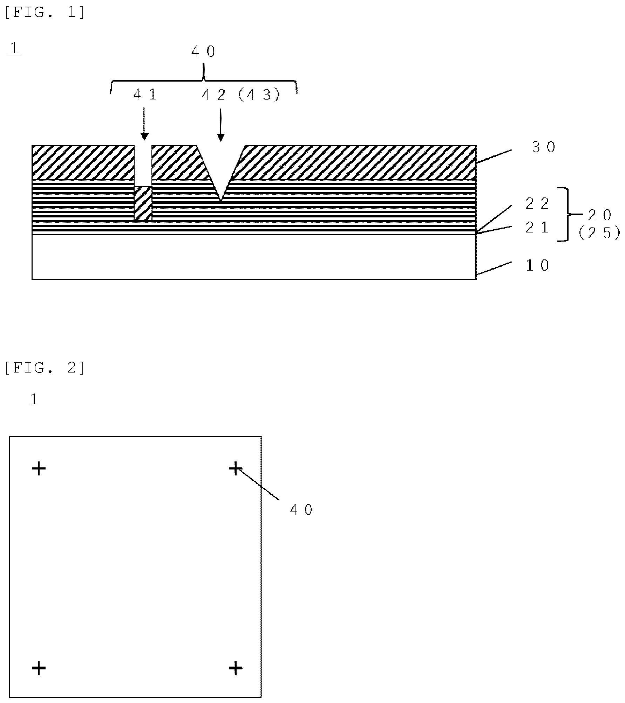

First, a reflective mask blank of the present invention will be described. FIG. 1 shows an example of a schematic view of the reflective mask blank according to the present invention. The reflective mask blank for EUV is described as an example, but the present invention is not limited to this. In FIG. 1, a reflective mask blank 1 first has a substrate 10, a multilayer reflective film 20 that is formed on a surface of the substrate 10 and reflects exposure light, an absorber film 30 that is formed on the multilayer reflective film 20 and absorbs exposure light, and a reference mark 40 formed on a surface of the reflective mask blank. Though not illustrated in FIG. 1, a protective film for preventing damage to the multilayer reflective film 20 during pattern formation to the absorber film 30 may be formed between the multilayer reflective film 20 and the absorber film 30. Further, a hard mask film that functions as an etching mask when dry-etching the absorber film 30 may be provided on the absorber film 30. Furthermore, a conductive film having a function as an antistatic layer during electrostatic chucking may be provided on a back surface side of the substrate 10. Furthermore, other functional layers may be provided.

The substrate 10 preferably has low thermal expansion characteristics for use in EUV light exposure, and is preferably formed from, for example, a material whose thermal expansion coefficient is within a range of $\pm 2 \times 10^{-8}/°C$, and preferably in a range of $\pm 5 \times 10^{-9}/°C$. Further, the substrate 10 having a front surface sufficiently flattened is preferably used, and surface roughness of a main surface of the substrate 10 is 0.5 nm or less, and preferably 0.2 nm or less in particular, in terms of RMS value. The surface roughness like this can be obtained by polishing or the like of the substrate 10.

The multilayer reflective film 20 is generally a multilayer film made by alternately stacking a low-refractive index material and a high-refractive index material, and in this case, is a film that reflects EUV light that is exposure light. In the mode in FIG. 1, the multilayer reflective film 20 has a stacked layer portion 25 composed of multiple layers in which layers 21 having a relatively high refractive index with respect to EUV light and layers 22 having a relatively low refractive index with respect to EUV light are alternately stacked. In the stacked layer portion 25, for the layer 21 having a relatively high refractive index with respect to the EUV light, what is made by periodically stacking Si (silicon) is preferably used, and for the layer 22 having a relatively low refractive index with respect to the EUV light, what is made by periodically stacking Mo (molybdenum) is preferably used (in this case, the stacked layer portion 25 is an Si/Mo stacked layer portion). Here, the Si layer 21 and the Mo layer 22 may be respectively layers formed from elemental silicon and elemental molybdenum, or may contain other components. Furthermore, a diffusion prevention layer may be provided between the Si layer 21 and the Mo layer 22. The diffusion prevention layer may be provided entirely or may be provided partly, between the Si layers 21 and the Mo layers 22.

The numbers of stacked Si layers 21 and Mo layers 22 are preferably, for example, 40 periods or more (40 layers or more for each), and are preferably 60 periods or less (60 layers or less for each).

Thicknesses of the Si layer 21 and the Mo layer 22 of the Si/Mo stacked layer portion 25 are properly set according to an exposure light wavelength, the thickness of the Si layer 21 is preferably 5 nm or less, and the thickness of the Mo layer 22 is preferably 4 nm or less. A lower limit of the thickness of the Si layer 21 is not particularly limited, but usually is 1 nm or more. A lower limit of the thickness of the Mo layer 22 is not particularly limited, but is usually 1 nm or more. The thicknesses of the Si layer 21 and the Mo layer 22 can be set so that high reflectance can be obtained with respect to EUV light. Furthermore, each of the thicknesses of the Si layers 21 and the Mo layers 22 may be constant or may be different in individual layers. A thickness of the entire Si/Mo stacked layer portion 25 is usually about 250 to 450 nm.

Furthermore, the multilayer reflective film 20 may have a structure having an Si/Ru stacked layer portion 25 composed of multiple layers in which Si (silicon) layers 21 and Ru (ruthenium) layers 22 are alternately stacked.

There are no restrictions on the material of the absorber film 30 as long as it is a material that absorbs exposure light and enables pattern processing. As the material of the absorber film 30, a material containing tantalum (Ta) or chrome (Cr) is preferably used, for example. The material containing Ta or Cr may contain oxygen (O), nitrogen (N), carbon (C), boron (B) and the like. Examples of materials containing Ta include elemental Ta and tantalum compounds such as TaO, TaN, TaON, TaC, TaCN, TaCO, TaCON, TaB, TaOB, TaNB, TaONB, TaCB, TaCNB, TaCOB, and TaCONB. Specific examples of materials containing Cr include elemental Cr, and chrome compounds such as CrO, CrN, CrON, CrC, CrCN, CrCO, CrCON, CrB, CrOB, CrNB, CrONB, CrCB, CrCNB, CrCOB, and CrCONB. Further, a multilayer structure composed of these materials may be adopted. Furthermore, the absorber film 30 may function as a phase shift mask.

Furthermore, as described above, a protective film may be formed between the multilayer reflective film 20 and the absorber film 30. The protective film is required to have a function of protecting the multilayer reflective film 20 from various kinds of dry etching and cleaning in a reflective mask production step, an exposure environment during use of the reflective mask, a cleaning process in a reproduction step after use, and the like, and a protective film containing additive elements such as niobium (Nb), zirconium (Zr), titanium (Ti), and rhodium (Rh), and has resistance to various processes is preferably used, and may have a multilayer structure formed from these materials.

On a side apart from the substrate 10, on the absorber film 30, a hard mask film (etching mask film of the absorber film 30) that is preferably in contact with the absorber film 30 and has different etching characteristics from the absorber film 30 may be provided. This hard mask film is a film that functions as an etching mask when dry-etching the absorber film 30. This hard mask film may be left as a reflectance reduction layer for reducing a reflectance in a wavelength of light that is used, for example, in inspection such as pattern inspection, to be made a part of the absorber film 30, or may be removed so as not to remain on the EUV reflective mask, after an absorber pattern is formed.

As a material of the hard mask film, a material containing, for example, chrome (Cr) is preferably used, and the hard mask film may have a multilayer structure. A hard mask film formed from a material containing Cr is preferable particularly when the absorber film 30 is formed from a material containing Ta but not Cr.

The hard mask film can be formed by, for example, a magnetron sputtering method.

There is no particular limit to a thickness of the hard mask film, but it is usually about 5 to 20 nm.

On the back surface side of the substrate 10, a conductive film may be provided as an antistatic layer during electrostatic chucking. The conductive film preferably has sheet resistance of 100 $\Omega/\square$ or less, and there is no particular limit to the material. As the material of the conductive film, materials containing, for example, tantalum (Ta) or chrome (Cr) are preferably used. Further, the material containing Ta or Cr may contain oxygen (O), nitrogen (N), carbon (C), boron (B) and the like. Examples of the materials containing Ta include elemental Ta, and tantalum compounds such as TaO, TaN, TaON, TaC, TaCN, TaCO, TaCON, TaB, TaOB, TaNB, TaONB, TaCB, TaCNB, TaCOB, and TaCONB. Specific examples of the materials containing Cr include elemental Cr, and chrome compounds such as CrO, CrN, CrON, CrC, CrCN, CrCO, CrCON, CrB, CrOB, CrNB, CrONB, CrCB, CrCNB, CrCOB, and CrCONB. Furthermore, the conductive film may have a multilayer structure formed from these materials.

There is no particular limit to a thickness of the conductive film, but it is usually about 5 to 100 nm. The thickness of the conductive film is preferably formed such that the multilayer reflective film 20 and the absorber pattern, and a film stress are well balanced after the absorber pattern is formed.

The conductive film may be formed before the multilayer reflective film 20 is formed, or may be formed after all films on the multilayer reflective film 20 side of the substrate 10 are formed, or after some films on the multilayer reflective film 20 side of the substrate 10 are formed, the conductive film may be formed, and thereafter, remaining films on the multilayer reflective film 20 side of the substrate 10 may be formed.

The conductive film can be formed by, for example, a magnetron sputtering method.

Furthermore, the EUV reflective mask blank may be such that a resist film is formed on a side that is farthest from the substrate 10. The resist film is preferably an electron beam (EB) resist.

FIG. 2 shows an example of disposition of a reference mark. In FIG. 1 and FIG. 2, reference marks 40 are disposed at four corners one by one on a surface on a same side as the multilayer reflective film 20 of the reflective mask blank 1, but three or more reference marks 40 that are not on a same straight line are preferably formed, and places where the reference marks 40 are formed and the number of reference marks 40 are not particularly limited. However, in order to prevent overlap with the main pattern in the EUV reflective mask, it is desirable to form them outside a main pattern forming region.

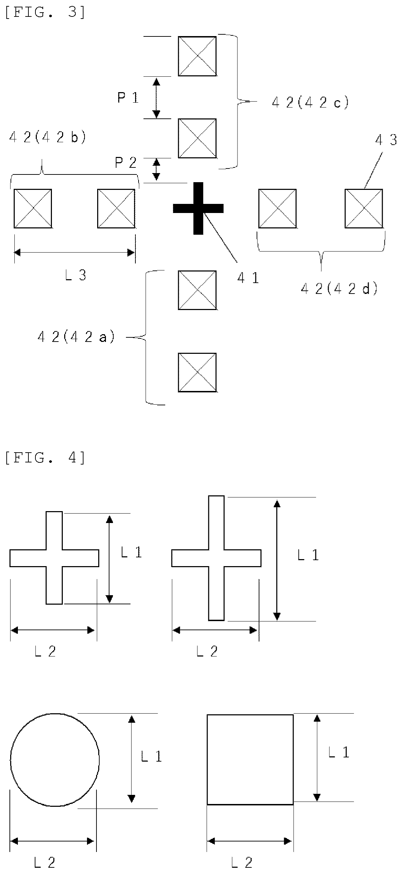

FIG. 3 shows shape examples and disposition examples of a main mark and auxiliary mark groups that configure the reference mark in the present invention. As shown in FIG. 3, the reference mark 40 consists of a main mark 41 that serves as a reference for a defect position, and auxiliary mark groups 42 disposed around (in surroundings of) the main mark 41, and the auxiliary mark group 42 is made up of a combination of a plurality of auxiliary marks 43. In FIG. 3, auxiliary mark groups 42 (42a, 42b, 42c, 42d) are disposed in four directions, above, below, left, and right of the main mark 41, but disposition directions of the auxiliary mark groups 42 are not particularly limited. As described later, it is sufficient if only the auxiliary mark group 42 consists of a plurality of auxiliary marks 43 that are formed at intervals from one another to extend in at least one direction starting from the main mark 41. For example, the auxiliary mark group 42 may extend in only one direction, either above, below, left, and right, of the main mark 41, or may extend in two or three directions. It is possible to reduce the number of auxiliary marks 43 that make up the auxiliary mark group 42 by limiting the extension directions of the auxiliary mark groups 42, which leads to improvement in throughput.

Since the main mark 41 serves as a reference for a defect position, it is desirably formed by FIB processing (hereinafter simply referred to as FIB) or lithography, which allows for high-precision processing. In FIG. 1, the main mark 41 is formed by removing a part of the multilayer reflective film 20, but it may be formed by removing a whole of the multilayer reflective film 20, it may be formed by removing the substrate under it, or it may be formed on the other layer such as the substrate 10 or the absorber film 30. Further, it may be formed across a plurality of layers. However, in order to make it serve as the reference position for a phase defect, it can be desirably used as the reference position in the defect inspection in the multilayer reflective film 20, and it is desirably formed on the substrate 10, the multilayer reflective film 20, or the protective film.

Furthermore, FIG. 4 shows shape examples of the main mark 41, but the shape of the main mark in the present invention is not limited to them. As shown in FIG. 4, cross shapes, a circular shape, a rectangular shape and the like in plan view are conceivable, and it is desirable that longitudinal and lateral lengths (sizes) L1 and L2 thereof are 0.1 $\mu$m or more since if they are too small, visibility will be poor. Furthermore, when the main mark 41 is formed by using FIB, the size thereof is desirably 500 $\mu$m or less, and more desirably 100 $\mu$m or less, since if the size is too large, it will take a long time to process. Furthermore, a depth of the main mark 41 is desirably 40 nm or more because if the depth is too small, contrast will be worsened, and it is desirably 500 nm or less in order to suppress damage to the substrate and facilitate reproduction. Furthermore, when the main mark 41 is formed by using FIB, the depth is more desirably 150 nm or less because if the depth is too large, it will take a long time to process. When the main mark 41 is formed by FIB, a current value thereof is desirably 100 pA or less since contrast during detection is enhanced by increasing a side wall angle of the mark in the sectional shape.

The auxiliary mark group 42 is made up by combination of a plurality of auxiliary marks 43. Since the auxiliary mark group 42 has a function as a landmark to find the main mark 41, it only needs to be large enough to be detected by an inspection machine or drawing machine, and a size thereof is not particularly limited, but specifically, the size L3 of the auxiliary mark group 42 is desirably larger than the main mark, and 50 $\mu$m or more, and desirably 1 mm or less (See FIG. 3).

The auxiliary marks 43 that make up the auxiliary mark group 42 can be multiple, and the number of auxiliary marks 43 is not particularly limited, but the number of auxiliary marks 43 is preferably a certain number or more to prevent loss of the function as landmarks, and is preferably a certain number or less to prevent a decrease in throughput. Thus, the number of auxiliary marks 43 that make up each of the auxiliary mark groups 42 is desirably, for example, three or more, and twenty or less.

Furthermore, an interval P1 between the adjacent auxiliary marks 43 is not limited, but the interval P1 between the adjacent auxiliary marks 43 is desirably 30 $\mu$m or less, because if the interval P1 is too large, it is difficult to determine in which direction the main mark 41 is located seen from a certain auxiliary mark 43 in a field of view of the inspection machine or the drawing machine, and it is difficult to fulfill the function as the landmark to find the main mark 41. For the similar reason, an interval P2 between the main mark 41 and the auxiliary mark 43 adjacent to the main mark 41 is also desirably 30 $\mu$m or less.

On the other hand, the interval P1 between the adjacent auxiliary marks 43 is desirably 3 $\mu$m or more, because if the interval P1 between the adjacent auxiliary marks 43 is too small, the required number of auxiliary marks 43 increases to thereby reduce the throughput, and a risk of damaging the substrate increases due to dense indentation or the like made to form the auxiliary marks 43. The interval P2 between the main mark 41 and the auxiliary mark 43 adjacent to the main mark 41 is desirably 3 $\mu$m or more because if the interval P2 is too small, there arises a risk of damaging the main mark 41 due to misalignment during indentation.

The auxiliary mark 43 is a constituent of the auxiliary mark group 42 that serves as a landmark of the main mark 41 and is a recessed portion that can be formed by an indentation method using a micro-indenter, for example.

In FIG. 1, the auxiliary mark 43 is formed by penetrating the absorber film 30 and penetrating a part of the multilayer reflective film 20, and a layer in which the auxiliary mark 43 is formed is not particularly limited. It may be formed in a same layer as the main mark 41 or may be formed in a different layer. Further, it may be formed across a plurality of layers. However, when the auxiliary mark 43 is formed on the substrate 10 or the multilayer reflective film 20 or the protective film, film formation is required after the auxiliary mark 43 is formed, and therefore, if a defect occurs in a step of forming the auxiliary mark 43, the defect is in the film and is unlikely to be removed by cleaning. Therefore, the auxiliary mark 43 is desirably formed after formation of the absorber film.

Furthermore, the auxiliary mark 43 is preferably formed after formation of the main mark 41. In doing so, the auxiliary mark 43 can be formed with the main mark 41 as a landmark, and it is not necessary to require excessive processing position precision for the apparatus that forms the auxiliary mark 43.

Further, as shown in FIG. 3, the plurality of auxiliary marks 43 that make up the auxiliary mark group 42 are all formed in a same shape and in a same orientation. Since the auxiliary marks 43 like them can be formed by only parallel movement of the substrate or the micro-indenter without rotating the micro-indenter during formation thereof by an indentation method using, for example, a micro-indenter, a complicated mechanism is not required, and there is no need to provide an extra drive unit on the substrate. Therefore, there is little risk of particle generation. Accordingly, a low-cost, low-defect reflective mask blank with no particle or the like attached is provided.

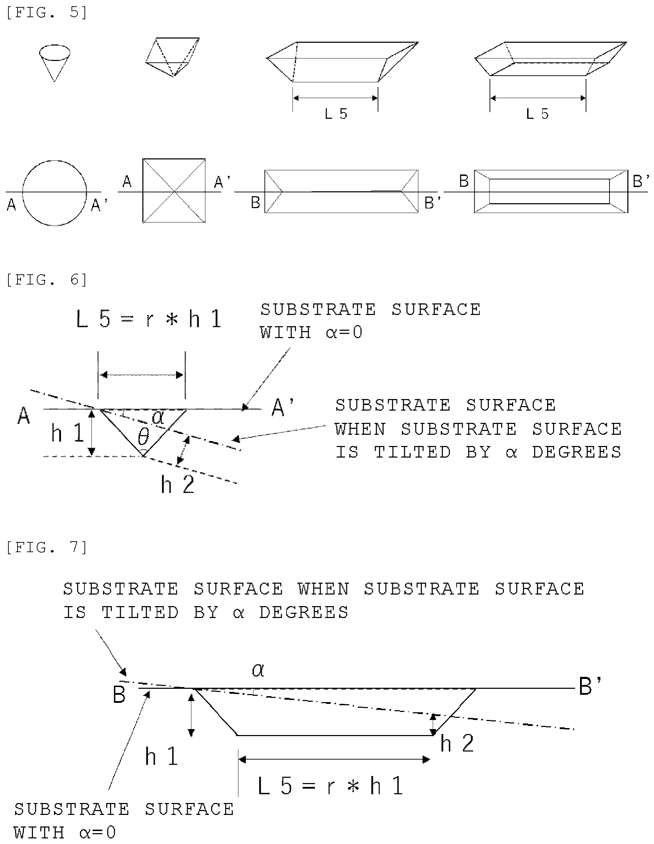

Further, although the shape examples of the auxiliary mark 43 are shown in FIG. 5, the shape of the auxiliary mark 43 in the present invention is not limited to this. Four patterns are shown, the upper row shows perspective shapes of the respective patterns, and the lower row shows shapes in plan view of the respective patterns. Note that these are also shape examples of micro-indenters (tip portions thereof in particular) used to form the auxiliary marks 43.

Two on the left are recessed portions in inverted cone or pyramid shapes (a left one is a cone, and a right one is a quadrangular pyramid). Further, the third from the left is a recessed portion in an inverted hipped roof shape. The last one is a recessed portion in an inverted truncated quadrangular pyramid shape. The auxiliary marks 43 are preferably recessed portions in these shapes.

A more preferable form of the auxiliary mark 43 is a recessed portion in an inverted cone or pyramid shape with a vertex angle of 55 degrees or more, a recessed portion in an inverted hipped roof shape with a ridge having a length of 50 μm or less, or a recessed portion in an inverted truncated quadrangular pyramid shape with a top surface having a long-side length of 50 μm or less.

This is because they are shapes that can be formed relatively easily and with high reproducibility. Detailed explanation on this point will be described later.

Next, a method for manufacturing the reflective mask blank of the present invention will be described.

Main steps include at least a step of forming the multilayer reflective film 20 on the substrate 10, and a step of forming the absorber film 30 on the multilayer reflective film 20. As necessary, it is also possible to form other functional layers such as the aforementioned protective film, a hard mask film, a conductive film, and a resist film. Methods for forming these films are not particularly limited, and these films can be formed in the same way as the conventional method (sputtering and the like) using the aforementioned materials, for example.

Furthermore, the method has a step of forming the reference mark 40 (the main mark 41 and the auxiliary mark groups 42) on a same side as the multilayer reflective film 20.

Note that, the main mark 41 is preferably formed on the substrate 10, the multilayer reflective film 20, or the protective film as described above. After the substrate is prepared, or after these films are formed, it is possible to form the main mark 41 with high precision by FIB processing, or lithography, for example.

Further, the auxiliary mark group 42 (a plurality of auxiliary marks 43) is preferably formed after formation of the absorber film 30 as described above, and is formed by an indentation method using a micro-indenter in the manufacturing method of the present invention. At this time, a plurality of auxiliary marks 43 are all formed in the same shape and in the same orientation with intervals from one another to extend in at least one direction starting from the main mark 41. By formation of the plurality of auxiliary marks 43 like this, the auxiliary mark group 42 is formed.

Since the method for formation of the auxiliary mark group 42 is the method by the indentation method with a micro-indenter like this, it can be carried out at low cost. Further, there is no need to rotate the micro-indenter as in the conventional method during formation of the auxiliary marks 43, as a result of which, it is possible to easily carry out the method by a relatively simple mechanism that moves the micro-indenter or the substrate parallel, for example. Further, it is possible to prevent a risk of particle generation by a drive mechanism or the like that rotates the micro-indenter, and the reflective mask blank can be manufactured with low defect.

A material forming a tip of the micro-indenter that forms the auxiliary marks 43 is not particularly limited, but rigid materials with durability such as diamond and sapphire are desirable.

A shape of the tip of the micro-indenter for forming the auxiliary marks 43 is not particularly limited, but in order to stabilize an indentation shape, as shown in FIG. 5, the micro-indenter in an inverted cone or pyramid shape (a cone, a quadrangular pyramid, etc.), the micro-indenter in an inverted hipped roof shape, or the micro-indenter in an inverted truncated quadrangular pyramid shape is prepared, and a structure in which a vertex, a side or a surface thereof is pressed against the substrate is desirable.

It is more preferable to use the one in an inverted cone or pyramid shape with the vertex angle of 55 degrees or more, the one in an inverted hipped roof shape with the ridge having a length of 50 μm or less, or the one in an inverted truncated quadrangular pyramid shape with the top surface having a long-side length of 50 μm or less. This point will be described in detail below.

FIG. 6 is a schematic view showing a sectional shape in an A-A' section of the auxiliary mark when using a micro-indenter in a cone or pyramid shape shown in FIG. 5, and a substrate surface when the substrate tilts. When the tip of the micro-indenter is in a cone or pyramid shape, change in the shape of the auxiliary mark is considered, when the substrate is tilted relative to the direction of indentation due to improper attachment of the micro-indenter or improper installation of the substrate as shown in FIG. 6.

$\theta$: angle of a micro-indenter tip (vertex angle)
$h1$: depth of the auxiliary mark in the state in which the substrate is not tilted
$h2$: depth of the auxiliary mark in a state in which the substrate is tilted
$L5$: length of the auxiliary mark in plan view
$r$: ratio of h1 and L5 (L5/h1)
$\alpha$: tilt of the substrate surface
$h2/h1$: variation rate of the depth of the auxiliary mark due to variations in $\theta$, $r$, and $\alpha$

Here, h2/h1 is expressed by formula 1 below, and the calculation result is shown in Table 1.

$$h2/h1 = \cos(\theta/2 + \alpha)/\cos(\theta/2) \ \ldots \ (\text{formula 1})$$

[Table 1]

| Θ [deg] | r | α [mrad] | | | | | | | | | | |
|---|---|---|---|---|---|---|---|---|---|---|---|---|
| | | 0 | 2 | 4 | 6 | 8 | 10 | 12 | 14 | 16 | 18 | 20 |
| 30 | 0.54 | 1.00 | 1.00 | 1.00 | 1.00 | 1.00 | 1.00 | 1.00 | 1.00 | 1.00 | 1.00 | 0.99 |
| 40 | 0.73 | 1.00 | 1.00 | 1.00 | 1.00 | 1.00 | 1.00 | 1.00 | 0.99 | 0.99 | 0.99 | 0.99 |
| 50 | 0.93 | 1.00 | 1.00 | 1.00 | 1.00 | 1.00 | 1.00 | 0.99 | 0.99 | 0.99 | 0.99 | 0.99 |
| 55 | 1.04 | 1.00 | 1.00 | 1.00 | 1.00 | 1.00 | 0.99 | 0.99 | 0.99 | 0.99 | 0.99 | 0.99 |
| 60 | 1.15 | 1.00 | 1.00 | 1.00 | 1.00 | 1.00 | 0.99 | 0.99 | 0.99 | 0.99 | 0.99 | 0.99 |
| 70 | 1.40 | 1.00 | 1.00 | 1.00 | 1.00 | 0.99 | 0.99 | 0.99 | 0.99 | 0.99 | 0.99 | 0.99 |
| 80 | 1.68 | 1.00 | 1.00 | 1.00 | 0.99 | 0.99 | 0.99 | 0.99 | 0.99 | 0.99 | 0.98 | 0.98 |
| 90 | 2.00 | 1.00 | 1.00 | 1.00 | 0.99 | 0.99 | 0.99 | 0.99 | 0.99 | 0.98 | 0.98 | 0.98 |
| 100 | 2.38 | 1.00 | 1.00 | 1.00 | 0.99 | 0.99 | 0.99 | 0.99 | 0.98 | 0.98 | 0.98 | 0.98 |
| 110 | 2.86 | 1.00 | 1.00 | 0.99 | 0.99 | 0.99 | 0.99 | 0.98 | 0.98 | 0.98 | 0.97 | 0.97 |
| 120 | 3.46 | 1.00 | 1.00 | 0.99 | 0.99 | 0.99 | 0.98 | 0.98 | 0.98 | 0.97 | 0.97 | 0.97 |
| 130 | 4.29 | 1.00 | 1.00 | 0.99 | 0.99 | 0.98 | 0.98 | 0.97 | 0.97 | 0.97 | 0.96 | 0.96 |
| 140 | 5.49 | 1.00 | 0.99 | 0.99 | 0.98 | 0.98 | 0.97 | 0.97 | 0.96 | 0.96 | 0.95 | 0.94 |
| 150 | 7.46 | 1.00 | 0.99 | 0.99 | 0.98 | 0.97 | 0.96 | 0.96 | 0.95 | 0.94 | 0.93 | 0.93 |
| 160 | 11.34 | 1.00 | 0.99 | 0.98 | 0.97 | 0.95 | 0.94 | 0.93 | 0.92 | 0.91 | 0.90 | 0.89 |
| 170 | 22.86 | 1.00 | 0.98 | 0.95 | 0.93 | 0.91 | 0.89 | 0.86 | 0.84 | 0.82 | 0.79 | 0.77 |

It is found that the variation of the depth of the auxiliary mark (h2/h1) relative to the variation of α is gentle. That is, it is found that the shape of the auxiliary mark is stabilized by making the tip shape of the micro-indenter cone or pyramid.

Here, the length L5 of the auxiliary mark in plan view is desirably 500 nm or more because if it is too small, visibility will be worsened. On the other hand, when reproduction of the substrate is considered, the depth of the auxiliary mark is desirably about the film thickness to suppress damage to the substrate, and is desirably 500 nm or less. In order to satisfy h1≤500 nm and L5≥500 nm, it is necessary to establish r≥1, and for this purpose, it is desirable to make θ 55 degrees or more from Table 1. Further, θ like this can prevent worsening of durability due to the tip shape of the micro-indenter becoming too thin, and reduce the risk of particle generation due to damage to the micro-indenter during indentation.

On the other hand, FIG. 7 is a schematic view showing a sectional shape in a B-B' section of the auxiliary mark when using the micro-indenter in a hipped roof shape shown in FIG. 5, and a substrate surface when the substrate is tilted. When the tip of the micro-indenter has a shape such as a hipped roof shape or a truncated quadrangular pyramid shape that presses the side or the surface thereof against the substrate, the change of the auxiliary mark shape is considered when the substrate is tilted relative to the indentation direction due to improper attachment of the micro-indenter or improper installation of the substrate as shown in FIG. 7.

h1: depth of the auxiliary mark in the state in which the substrate is not tilted
h2: smaller one of the depths of the auxiliary mark in the state in which the substrate is tilted
L5: length of the bottom portion of the auxiliary mark (length of the ridge)
r: ratio of h1 and L5 (L5/h1)
α: tilt of a substrate surface
h2/h1: variation rate of depth in both ends of the auxiliary mark due to variations in r and α

Here, h2/h1 is expressed by formula 2 below, and the calculation result is shown in Table 2.

$$h2/h1 = 1 - r\tan\alpha \quad \cdots \text{(formula 2)}$$

[Table 2]

| r | α [mrad] | | | | | | | | | | | | | | | | | | | | |
|---|---|---|---|---|---|---|---|---|---|---|---|---|---|---|---|---|---|---|---|---|---|
| | 0 | 0.2 | 0.4 | 0.6 | 0.8 | 1 | 1.2 | 1.4 | 1.6 | 1.8 | 2 | 2.2 | 2.4 | 2.6 | 2.8 | 3 | 3.2 | 3.4 | 3.6 | 3.8 | 4 |
| 1 | 1.00 | 1.00 | 1.00 | 1.00 | 1.00 | 1.00 | 1.00 | 1.00 | 1.00 | 1.00 | 1.00 | 1.00 | 1.00 | 1.00 | 1.00 | 1.00 | 1.00 | 1.00 | 1.00 | 1.00 | 1.00 |
| 10 | 1.00 | 1.00 | 1.00 | 0.99 | 0.99 | 0.99 | 0.99 | 0.99 | 0.98 | 0.98 | 0.98 | 0.98 | 0.98 | 0.97 | 0.97 | 0.97 | 0.97 | 0.97 | 0.96 | 0.96 | 0.96 |
| 20 | 1.00 | 1.00 | 0.99 | 0.99 | 0.98 | 0.98 | 0.98 | 0.97 | 0.97 | 0.96 | 0.96 | 0.96 | 0.95 | 0.95 | 0.94 | 0.94 | 0.94 | 0.93 | 0.93 | 0.92 | 0.92 |
| 50 | 1.00 | 0.99 | 0.98 | 0.97 | 0.96 | 0.95 | 0.94 | 0.93 | 0.92 | 0.91 | 0.90 | 0.89 | 0.88 | 0.87 | 0.86 | 0.85 | 0.84 | 0.83 | 0.82 | 0.81 | 0.80 |
| 100 | 1.00 | 0.98 | 0.96 | 0.94 | 0.92 | 0.90 | 0.88 | 0.86 | 0.84 | 0.82 | 0.80 | 0.78 | 0.76 | 0.74 | 0.72 | 0.70 | 0.68 | 0.66 | 0.64 | 0.62 | 0.60 |
| 200 | 1.00 | 0.96 | 0.92 | 0.88 | 0.84 | 0.80 | 0.76 | 0.72 | 0.68 | 0.64 | 0.60 | 0.56 | 0.52 | 0.48 | 0.44 | 0.40 | 0.36 | 0.32 | 0.28 | 0.24 | 0.20 |
| 500 | 1.00 | 0.90 | 0.80 | 0.70 | 0.60 | 0.50 | 0.40 | 0.30 | 0.20 | 0.10 | -0.00 | -0.10 | -0.20 | -0.30 | -0.40 | -0.50 | -0.60 | -0.70 | -0.80 | -0.90 | -1.00 |
| 1000 | 1.00 | 0.80 | 0.60 | 0.40 | 0.20 | -0.00 | -0.20 | -0.40 | -0.60 | -0.80 | -1.00 | -1.20 | -1.40 | -1.60 | -1.80 | -2.00 | -2.20 | -2.40 | -2.60 | -2.80 | -3.00 |

As compared with the case of the cone or pyramid shape shown in Table 1, in the hipped roof shape, when r increases, the variation of the ratio of the depth in both ends of the indentation shape following increase in α increases, and it is found that when the length L5 is long relative to the depth h1 of the auxiliary mark, the shape of the auxiliary mark varies due to a slight tilt of the substrate surface.

When reproduction of the substrate is considered, the depth of the auxiliary mark is desirably about the film thickness, for example, to suppress damage to the substrate, and is desirably 500 nm or less. Further, in order to allow for the tilt α of the substrate surface up to 1 mrad, and keep the variation rate h2/h1 of the depth of both the ends of the auxiliary mark within 10%, it is necessary to establish r≤100, and in the case of h1≤500 nm, the length of the surface or the side (length of the ridge), that is pressed against the substrate, of the micro-indenter is desirably 50 μm or less, from Table 2.

Note that the case of using the micro-indenter in a truncated quadrangular pyramid shape can also be considered substantially similarly to the case of the hipped roof shape, and in the case of h1≤500 nm, the length of the surface or the side (long-side length of the top surface), that is pressed against the substrate, of the micro-indenter is desirably 50 μm or less.

Further, as is found from Table 1 and Table 2, by using the micro-indenter in a cone or pyramid shape, the variation (h2/h1) of the depth of the auxiliary mark is gentler relative to the variation of α than in the case of using the micro-indenter in a hipped roof shape or a truncated quadrangular pyramid shape, and therefore, use of the micro-indenter in a cone or pyramid shape is more preferable from the viewpoint of stability (shape stability) of reproduction of the auxiliary mark.

Since the need for high precision can be eliminated in terms of installation of the substrate, and excessively highly precise attachment of the micro-indenter to the mechanism that is used during the indentation method, the shapes of the micro-indenter as described above (particularly the cone or pyramid shape among them) are preferred.

Here, the significance of forming the auxiliary mark group 42 will be described again. A position of the reference mark 40 can be identified by a defect inspection machine (for example, MAGICS series manufactured by Lasertec Corporation), a coordinate measurement apparatus (for example, LMS IPRO series manufactured by KLA-Tencor Corporation), an electron beam drawing machine (for example, MBM series manufactured by Nuflare Technology, Inc.), and the like, but if a deviation in the coordinate system between the apparatus that produces the main mark 41 and the above-described detector can be grasped in advance, the reference mark 40 can be detected relatively easily by inspecting a position that is shifted by the amount of the deviation in the coordinate system from the design position of the main mark 41. In this case, the auxiliary mark group 42 is not necessarily required, and detection is possible by using only the main mark 41.

However, it is not necessarily easy for the mask shop to accurately grasp the amount of the deviation between the coordinate system of the apparatus that forms the main mark 41 formed by the blank maker, and the coordinate system of the in-house inspection machine or drawing machine owned by the mask shop, and in such a case, the mask shop searches for the main mark 41 using the auxiliary mark groups 42 as a clue.

Note that it is also possible to use an indentation function using a micro-indenter mounted on the defect inspection machine when forming the auxiliary marks 43. In this case, it is not necessary to newly introduce an apparatus to form the auxiliary marks 43, and it is possible to suppress cost.

Example

Hereinafter, the present invention will be more specifically described with reference to Examples and Comparative Examples. However, the present invention is not limited thereto.

(Example 1)

The multilayer reflective film 20 was formed on the substrate 10 formed of quartz glass measuring 152 mm square and 6.35 mm thick, by DC pulse magnetron sputtering using a molybdenum (Mo) target and a silicon (Si) target, with both the targets and the main surface of the substrate 10 facing each other, while the substrate 10 was rotated on its axis. The respective targets were attached to a sputtering apparatus capable of mounting two targets and discharging electricity to the targets one by one or both simultaneously, and the substrate 10 was placed thereon. First, power was applied to the silicon (Si) target while argon (Ar) gas was flown into a chamber to form a silicon (Si) layer having a thickness of 4 nm, and application of the power to the silicon (Si) target was stopped. Subsequently, power was applied to the molybdenum (Mo) target while argon (Ar) gas was flown into the chamber to form a molybdenum (Mo) layer having a thickness of 3 nm, and application of the power to the molybdenum (Mo) target was stopped. The operation of forming the silicon (Si) layer and the molybdenum (Mo) layer constituted one cycle, and this cycle was repeated 40 times to form the multilayer reflective film 20.

Next, a protective film in contact with the multilayer reflective film 20 was formed on the multilayer reflective film 20 by DC pulse magnetron sputtering using an Ru target, with the Ru target facing the main surface of the substrate 10, while the substrate 10 was rotated on its axis.

Next, by irradiating a predetermined part of the protective film with FIB, all of the protective film and a part of the multilayer reflective film 20 of the irradiated part were removed, and the main mark 41 having a cross shape with a width of 1 $\mu$m and a length of 5 $\mu$m in plan view was formed. At this time, the current value of FIB was about 50 pA. When observed by an atomic force microscope (AFM), the depth of the main mark 41 was 100 nm.

Next, the protective film surface was inspected by the defect inspection machine. In this defect inspection, a map 1 including the position of the main mark 41 and information on the defect position on the protective film surface was obtained. Since the deviation between the coordinate system of FIB that formed the main mark 41 and the coordinate system of the defect inspection machine was grasped in advance, the main mark 41 was able to be easily detected by inspecting the position obtained by shifting the search position of the mark by the amount of deviation in the coordinate system from the design position. On the other hand, when mark detection was tried with the processing coordinates in the coordinate system of FIB as the target without considering the deviation between the coordinate system of FIB and the coordinate system of the defect inspection machine, the main mark 41 was not able to be detected within the field of view of the defect inspection machine, and the main mark was detected by spirally exploring the surrounding area, as a result of which, it took longer to detect the main mark 41 as compared to when the deviation of the coordinate system was corrected.

Next, the absorber film 30 in contact with the protective film was formed on the protective film by DC pulse magnetron sputtering using a Ta target, with the Ta target and the main surface of the substrate 10 facing each other, while the substrate 10 was rotated on its axis.

Next, the surface of the absorber film 30 was inspected by the defect inspection machine. In this defect inspection, a map 2 including the position of the main mark 41 and the information on the defect position on the surface of the absorber film 30 was obtained. Since the deviation between the coordinate system of FIB that formed the main mark 41 and the coordinate system of the defect inspection machine was grasped in advance, the main mark 41 was able to be easily detected by inspecting the search position of the mark by shifting the search position of the mark by the amount of deviation of the coordinate system from the design position. On the other hand, when mark detection was tried with the processing coordinates in the coordinate system of FIB as the target without considering the deviation between the coordinate system of FIB and the coordinate system of the defect inspection machine, the main mark 41 was not able to be detected within the field of view of the defect inspection machine, and the main mark was detected by spirally exploring the surrounding area, as a result of which, it took longer to detect the main mark 41 as compared to when the deviation of the coordinate system was corrected.

Next, the hard mask film in contact with the absorber film 30 was formed on the absorber film 30 by DC pulse magnetron sputtering using a Cr target, with the Cr target and the main surface of the substrate 10 facing each other, while the substrate 10 was rotated on its axis, and the EUV reflective mask blank was produced.

Next, a plurality of auxiliary marks 43 were formed around the main mark 41 transferred on the hard mask film by the indentation method, by using the micro-indenter in which the tip shape was a quadrangular pyramid and the tip of the quadrangular pyramid was at 136 degrees, and formation of the auxiliary mark groups 42 was performed. At this time, by repeating indentation, and movement of the stage on which the substrate was placed, ten auxiliary marks 43 (each having a size in plan view of approximately 5 $\mu$m square) were formed on each of the top, bottom, left and right of the main mark in plan view. The distance P1 between the adjacent auxiliary marks 43 was 10 $\mu$m, and the size L3 of the auxiliary mark group 42 was designed in advance to be approximately 140 $\mu$m resultantly.

Next, the surface of the hard mask film was inspected by the defect inspection machine. In this defect inspection, a map 3 including the position of the main mark 41 and the information on the defect position on the surface of the hard mask film was obtained. Since the deviation between the coordinate system of FIB that formed the main mark 41 and the coordinate system of the defect inspection machine was grasped in advance, the main mark 41 was able to be easily detected by inspecting the search position of the mark by shifting the search position of the mark by the amount of the deviation of the coordinate system based from the design position. On the other hand, when mark detection was tried with the processing coordinates in the coordinate system of FIB as the target without considering the deviation between the coordinate system of FIB and the coordinate system of the defect inspection machine, the main mark 41 was not able to be detected within the field of view of the defect inspection machine, but the auxiliary mark groups 42 were able to be detected. By using the auxiliary mark groups 42 as a clue, the main mark 41 was able to be detected relatively easily.

The produced reference mark 40 was observed by SEM. When mark detection was tried with the processing coordinates in the coordinate system of FIB as the target without considering the deviation between the coordinate system of FIB and the coordinate system of SEM, the auxiliary mark groups 42 were confirmed within the field of view of SEM.

Furthermore, when the central part of the reference mark 40 was observed with increased magnification with the auxiliary mark groups 42 as the clue, the main mark 41 was confirmed. Ten auxiliary marks 43 were able to be confirmed on each of the top, bottom, left, and right of the main mark 41, and it was confirmed that each of them had the size in plan view of approximately 5 $\mu$m square and was formed with excellent shape reproducibility. Furthermore, it was confirmed that the size of the auxiliary mark group 42 was approximately 140 $\mu$m, and was shaped as designed.

It should be noted that the present invention is not limited to the above-described embodiment. The embodiment is just an example, and any examples that substantially have the same feature and demonstrate the same functions and effects as those in the technical concept disclosed in claims of the present invention are included in the technical scope of the present invention.

**Claims**

1.  A reflective mask blank comprising at least:

    a substrate;
    a multilayer reflective film provided on the substrate, the multilayer reflective film reflecting exposure light; and
    an absorber film provided on the multilayer reflective film, the absorber film absorbing the exposure light, wherein
    the reflective mask blank further comprises a reference mark formed on a surface on a same side as the multilayer reflective film of the reflective mask blank,
    the reference mark consists of a main mark serving as a reference position for a defect position, and an auxiliary mark group disposed around the main mark,
    the auxiliary mark group consists of a plurality of auxiliary marks formed at intervals from one another to extend in at least one direction starting from the main mark, and
    the plurality of auxiliary marks are all formed in a same shape and in a same orientation.

2.  The reflective mask blank according to claim 1,

    wherein each of the auxiliary marks
    is a recessed portion in an inverted cone or pyramid shape with a vertex angle of 55 degrees or more, a recessed portion in an inverted hipped roof shape with a ridge having a length of 50 $\mu$m or less, or a recessed portion in an inverted truncated quadrangular pyramid shape with a top surface having a long-side length of 50 $\mu$m or less.

3.  The reflective mask blank according to claim 1 or claim 2, wherein the auxiliary marks are formed on a same layer as the main mark, or above a layer on which the main mark is formed.

4.  A method for manufacturing a reflective mask blank, comprising at least steps of:

    forming a multilayer reflective film on a substrate, the multilayer reflective film reflecting exposure light; and
    forming an absorber film on the multilayer reflective film, the absorber film absorbing the exposure light, wherein
    the method further comprises a step of forming a reference mark on a surface on a same side as the multilayer reflective film of the reflective mask blank, the reference mark consisting of a main mark serving as a reference position for a defect position, and an auxiliary mark group disposed around the main mark,
    when forming the auxiliary mark group of the reference mark, a plurality of auxiliary marks are all formed in a same shape and in a same orientation at intervals from one another to extend in at least one direction starting from the main mark, by an indentation method with a micro-indenter, and thereby the auxiliary mark group consisting of the plurality of auxiliary marks is formed.

5.  The method for manufacturing a reflective mask blank according to claim 4,

    wherein as the micro-indenter,
    a micro-indenter in an inverted cone or pyramid shape with a vertex angle of 55 degrees or more, a micro-indenter in an inverted hipped roof shape with a ridge having a length of 50 $\mu$m or less, or a micro-indenter in an inverted truncated quadrangular pyramid shape with a top surface having a long-side length of 50 $\mu$m or less is used.

6.  The method for manufacturing a reflective mask blank according to claim 4, wherein when forming the main mark, the main mark is formed by FIB processing.

7.  The method for manufacturing a reflective mask blank according to claim 5, wherein when forming the main mark, the main mark is formed by FIB processing.

8.  The method for manufacturing a reflective mask blank according to any one of claim 4 to claim 7, wherein when forming the auxiliary marks, a defect inspection machine equipped with the micro-indenter is used.

9.  The method for manufacturing a reflective mask blank according to any one of claim 4 to claim 7, wherein the auxiliary marks are formed after formation of the main mark.

**10.** The method for manufacturing a reflective mask blank according to claim 8, wherein the auxiliary marks are formed after formation of the main mark.

[FIG. 1]

[FIG. 2]

[FIG. 3]

P1

4 2 ( 4 2 b )

4 2 ( 4 2 c )

P2

4 3

L 3

4 1

4 2 ( 4 2 d )

4 2 ( 4 2 a )

[FIG. 4]

L 1

L 2

L 1

L 2

L 1

L 2

L 1

L 2

[FIG. 5]

[FIG. 6]

$$L5 = r * h1$$

SUBSTRATE SURFACE
WITH α=0

SUBSTRATE SURFACE
WHEN SUBSTRATE SURFACE
IS TILTED BY α DEGREES

A — $h1$ — $\alpha$ — $\theta$ — $h2$ — A'

[FIG. 7]

SUBSTRATE SURFACE WHEN SUBSTRATE SURFACE
IS TILTED BY α DEGREES

B — $\alpha$ — $h1$ — $h2$ — B'

$$L5 = r * h1$$

SUBSTRATE SURFACE
WITH α=0

17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6713251 B